# EUROPEAN PATENT SPECIFICATION

(11) **EP 4 416 760 B1**
(45) Date of publication and mention of the grant of the patent: **21.10.2026**
(21) Application number: 22881526.2
(22) Date of filing: 16.08.2022
(51) Int. Cl.: H10P 90/00, H10W 10/00, H10W 10/20, H10W 40/10, H10W 40/22, H10W 90/00, H10W 10/10

(54) **THERMAL ISOLATION BETWEEN EMBEDDED MECA MODULES**
THERMISCHE ISOLATION ZWISCHEN EINGEBETTETEN MECA-MODULEN
ISOLATION THERMIQUE ENTRE MODULES MECA INTÉGRÉS

(30) Priority: 15.10.2021 US 202163256480 P; 15.08.2022 US 202217888006
(43) Date of publication of application: 21.08.2024
(73) Proprietor: HRL Laboratories LLC, Malibu, CA 90265-4797 (US)
(72) Inventor: HERRAULT, Florian, Malibu, California 90265-4797 (US)
(74) Representative: Lusinchi, Laurent Pierre
(86) International application number: PCT/US2022/040474
(87) International publication number: WO 2023/064032

(56) References cited:
- US-A1- 2008 318 360
- US-A1- 2009 057 874
- US-A1- 2020 294 816
- US-A1- 2020 335 480
- US-A1- 2021 233 857
- US-B1- 8 617 927

## Description

### TECHNICAL FIELD

. This presentation relates to electronic assemblies; in particular electronic assemblies comprising one or more microelectronic components integrated into a microelectronic wafer fabricated separately, wherein at least one of said integrated microelectronic components produces heat capable of decreasing the performance of the other integrated microelectronic components.

### BACKGROUND

. Electronic assemblies, or hybrid circuits, comprise microelectronic circuits fabricated separately and assembled together so as to form a single component, which can itself be encapsulated in an electronic circuit package. Assembling microelectronic circuits fabricated separately allows one to, for example, test all the microelectronic circuits separately, prior to assembling them, which, in turn enables improved fabrication yields of the final component. This capability is particularly significant if some of the microelectronic circuits fabricated separately are difficult and/or expensive to manufacture. Assembling microelectronic circuits fabricated separately also allows one to combine microelectronic circuits made of different materials and/or using different manufacturing processes, into a single final component. This capability can lead to higher circuit performance.

. The reference P. Chinoy, N. Jain, Ping Li, J. Goodrich and C. Souchuns, "Manufacture of low-loss microwave circuits using HMIC technology," 1994 IEEE MTT-S International Microwave Symposium Digest (Cat. No.94CH3389-4), San Diego, CA, USA, 1994, pp. 1137-1140 vol.2. doi: 10.1109/MWSYM.1994.335544", discloses a low-cost, batch-processed, surface-mountable, microwave manufacturing technology that provides hybrid-type flexibility with monolithic-type passive components with repeatability and precision. The reference discloses, in particular, power amplifier circuits with high power-added efficiencies and reduced size paving the way for low-cost, high-performance circuits for wireless communication markets.

. US Patent number 8,617,927 and US Patent number 9,214,404 disclose a method and apparatus for mounting microelectronic chips to a thermal heat sink. The chips are arranged in a desired configuration with their active faces all facing a common direction and with their active faces defining a common planar surface for all of said chips. A metallic material is applied to the chip, preferably by electroplating to backsides of the chips, the metallic material being electro-formed thereon and making void-free contact with the backsides of the chips.

. US Patent number 9,508,652 discloses a method for wafer level packaging that includes forming one or more die, forming a plated metal ring (PMR) on each die, forming a cover wafer (CW), the CW having one or more plated seal rings, forming a body wafer (BW), the BW having cavities and a metal layer on a first side of the BW, aligning a respective die to the CW so that a PMR on the respective die is aligned to a respective plated seal ring (PSR) on the CW, bonding the PMR on the respective die to the respective PSR, aligning the BW to the CW so that a respective cavity of the BW surrounds each respective die bonded to the CW and so that the metal layer on the BW is aligned with at least one PSR on the CW, and bonding the metal layer on the first side of the BW to the PSR on the CW. Each PMR has a first height and each PSR has a second height.

. US Patent numbers 9,837,372 and 9,385,083 disclose an interconnect and manufacturing method for electrically coupling pads formed on adjacent chips (or on packaging material adjacent the chips) with an electrically conductive heat sink being disposed between the pads, the interconnect comprising a metallic membrane layer disposed between two adjacent pads and disposed, or bridging, over the electrically conductive heat sink so as to avoid making electrical contact with the electrically conductive heat sink. An electroplated metallic layer is disposed on the metallic membrane layer. Multiple interconnects can be formed in parallel using manufacturing techniques compatible with wafer level fabrication of the interconnects. The interconnects preferably follow a smooth curve to electrically connect adjacent pads and following that smooth curve they bridge over the intervening electrically conductive heat sink material in a predictable fashion.

. US Patent number 9,337,124 discloses a method for forming a wafer level heat spreader that includes providing a mesh wafer, the mesh wafer having a plurality of openings and mesh regions between the openings, bonding the mesh wafer to a backside of an integrated circuit (IC) wafer, the IC wafer comprising a plurality of circuits; and electroplating a heat sink material through the plurality of openings and onto to the backside of the IC wafer.

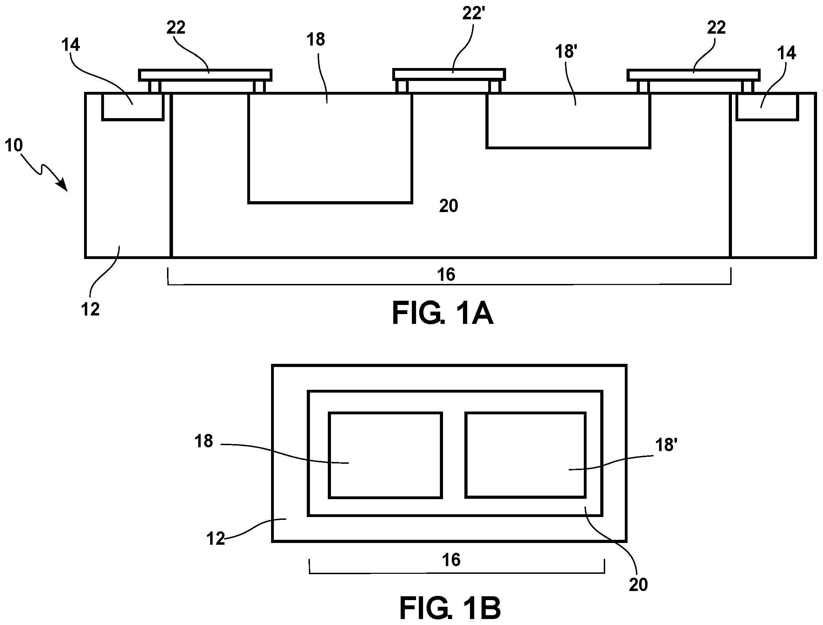

. US Patent No. 10998273 discloses an electronic assembly and manufacturing method thereof. As for the example illustrated in Figures 1A (cross-section view) and 1B (top view; not to scale, connections not shown) the electronic assembly 10 comprises a carrier wafer 12 with an electronic integrated circuit 14 formed therein and with a through-wafer cavity 16; at least one component chip (18, 18') being held in said through-wafer cavity 16 by direct contact with an attachment metal 20 that fills at least a portion of said through-wafer cavity 16 (the full cavity is filled by metal 20 in Figures 1A and 1B); said component chip (18, 18') further being electrically connected 22 to said integrated circuit 14. One or more conductors 22" can connect pads (not shown) on the different component chips (18, 18'). The heat conducting attachment metal 20 advantageously allows evacuating the heat generated by the operation of the component chip (18, 18'). However, the Inventor has noted that when at least one high power component chip (e.g. 18) is held by the heat conducting attachment material with other component chips (e.g. 18') in a same wafer cavity 16, as illustrated in Figures 1A, 1B, a thermal cross talk may appear between the high power component chip (e.g. 18) and the other component chips (e.g. 18') and detrimentally affect the operation of the other component chips (e.g. 18'). Chips 18 and 18' can have different form factors and can be made using fifferent materials and/or technologies.

. There exists a need for an electronic assembly or hybrid component that allows mitigating the thermal crosstalk between chips attached by metal in a same wafer cavity.

### SUMMARY

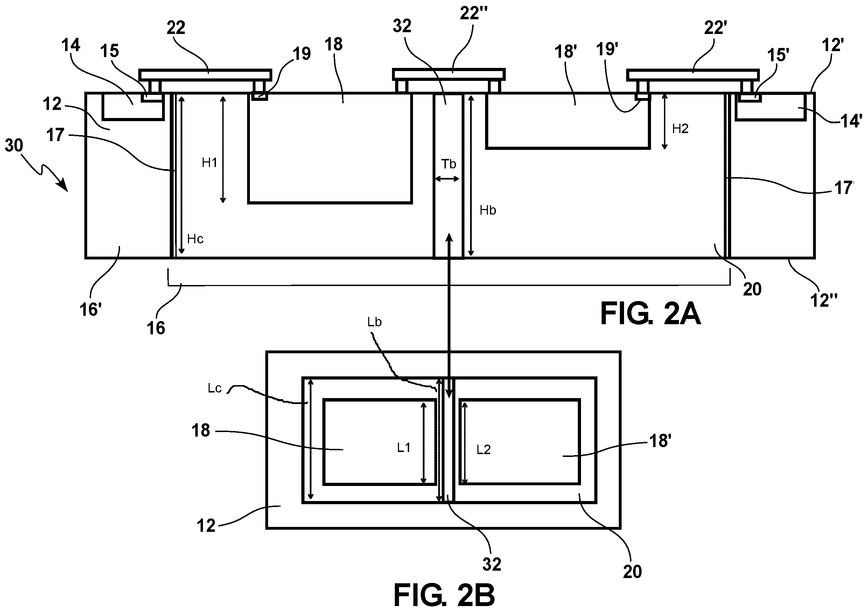

. **The invention is defined by the enclosed claims.** Embodiments of the presentation comprise an electronic assembly, having: -a carrier wafer with a top wafer surface and a bottom wafer surface; an electronic integrated circuit being formed in the carrier wafer and comprising first and second integrated circuit contact pads on one of the top wafer surface and the bottom wafer surface; said carrier wafer comprising a through-wafer cavity having walls that join said top wafer surface to said bottom wafer surface; -a first component chip with a first component chip top surface, a first component chip bottom surface and first component chip side surfaces, the first component chip being held in said through-wafer cavity by direct contact of at least a side surface of said first component chip with an heat conducting attachment material that fills at least a portion of said through-wafer cavity; said first component chip comprising at least one first component contact pad on one of said first component chip top surface and said first component chip bottom surface; -a second component chip with a second component chip top surface, a second component chip bottom surface and second component chip side surfaces, the second component chip being held in said through-wafer cavity by direct contact of at least a side surface of said second component chip with said heat conducting attachment material; said second component chip comprising at least one second component contact pad on one of said second component chip top surface and said second component chip bottom surface; wherein a barrier having a heat conductivity lower than a heat conductivity of said carrier wafer is held by said heat conducting attachment material in said through-wafer cavity between said first and said second component chips; and having at least one of: -a first conductor connecting said first integrated circuit contact pad and said first component contact pad; and -a second conductor connecting said second integrated circuit contact pad and said second component contact pad. According to an embodiment, the heat conducting attachment material can be a metal. Such embodiments are for example illustrated in Figures 2A-B, 3A-B and 4B-D.

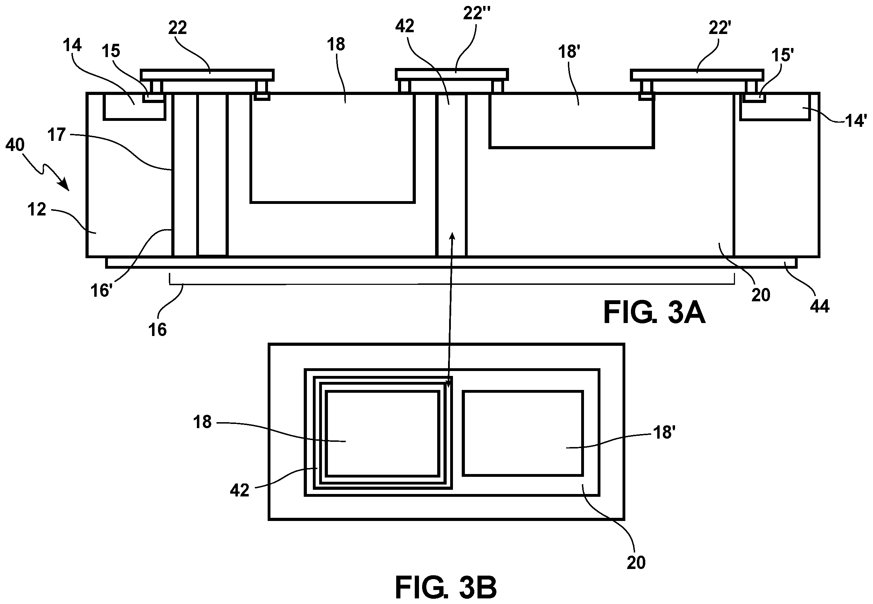

. According to embodiments of this presentation, the first and second component chips have first and second heights and the barrier has a barrier height at least as large as the smallest of the first and second heights. Such embodiments are for example illustrated in Figures 2A and 3A.

. According to embodiments of this presentation, the through-wafer cavity has a cavity height and the barrier height is equal to the cavity height. Such embodiments are for example illustrated in Figures 2A and3A.

. According to embodiments of this presentation, the first and second component chips have each a side closest to the barrier that have first and second lengths, and wherein the barrier has a barrier length at least as large as the smallest of said first and second lengths. Such embodiments are for example illustrated in Figures 2B, 3B and 4B-D.

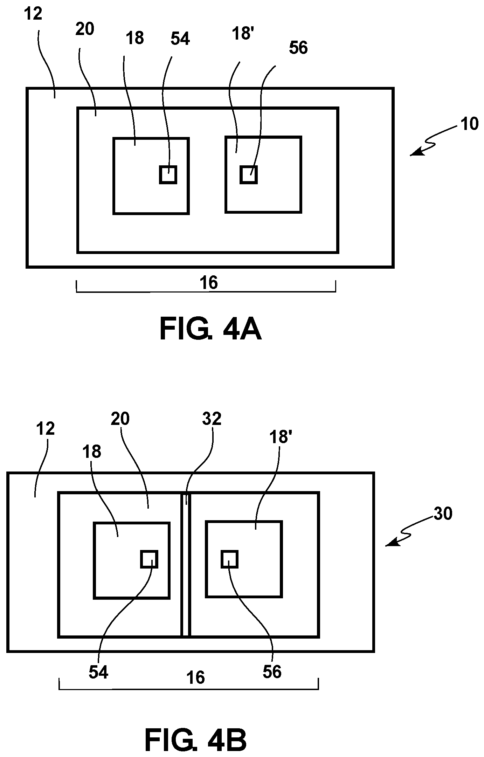

. According to embodiments of this presentation, the through-wafer cavity has a cavity length and the barrier length is equal to the cavity length. Such embodiments are for example illustrated in Figures 2B and 4B-C.

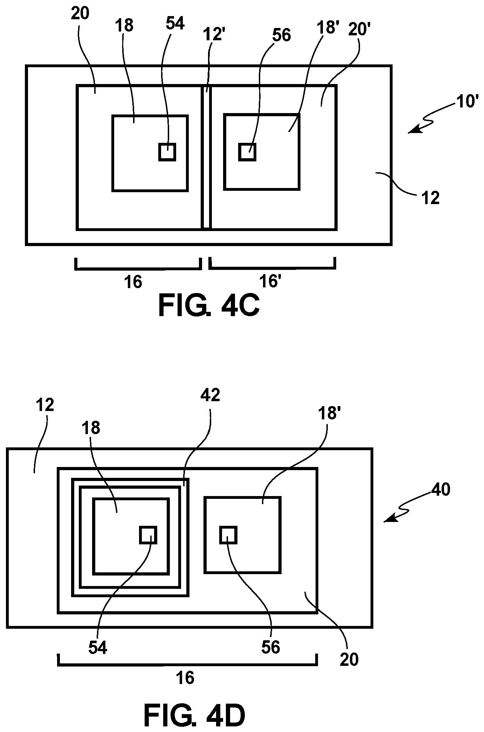

. According to embodiments of this presentation, the barrier is arranged parallel to at least two side surfaces of one of the first and second component chips. Such embodiments are for example illustrated in Figures 3A-B and 4D.

. According to embodiments of this presentation, the barrier surrounds one of the first and second component chips. Such embodiments are for example illustrated in Figures 3A-B and 4D.

. According to embodiments of this presentation, the barrier material comprises one of air and glass. Such embodiments are for example illustrated in Figures 2A-B, 3A-B and 4B-D. Ceramics can also be used where appropriate. According to embodiments of this presentation, the barrier material can comprise any material with a chemical resistance of the same order as air or glass, or having chemical inertness, and that has a low thermal conductivity (10 W / m K or below)

. According to embodiments of this presentation, the barrier has a thickness equal to one fifth or moreof the distance between the first and second component chips.

. According to embodiments of this presentation, the heat conducting attachment material holds the first and second component chips such that the first and second component chips top surfaces are flush with the top wafer surface. Such embodiments are for example illustrated in Figures 2A and 3A.

. According to embodiments of this presentation, a metal layer covers at least a portion of the bottom wafer surface as well as the heat conducting attachment material in the cavity. Such embodiments are for example illustrated in Figure 3A.

. According to embodiments of this presentation, the walls of the through-wafer cavity are covered with a dielectric layer. Such embodiments are for example illustrated in Figures 2A-B, 3A-B and 4B-D.

. According to embodiments of this presentation, the attachment material contacts at least most of each first and second component chips side surfaces. Such embodiments are for example illustrated in Figures 2A-B, 3A-B and 4B-D.

. According to embodiments of this presentation, the carrier wafer and at least the first or second component chips are made of different materials. Such embodiments are for example illustrated in Figures 2A-B, 3A-B and 4B-D.

. According to embodiments of this presentation, at least one of the first and second component chips is an integrated circuit chip comprising one or more transistors.

. According to embodiments of this presentation, the carrier wafer and at least one of the first and second component chips have a different height. Such embodiments are for example illustrated in Figures 2A and 3A.

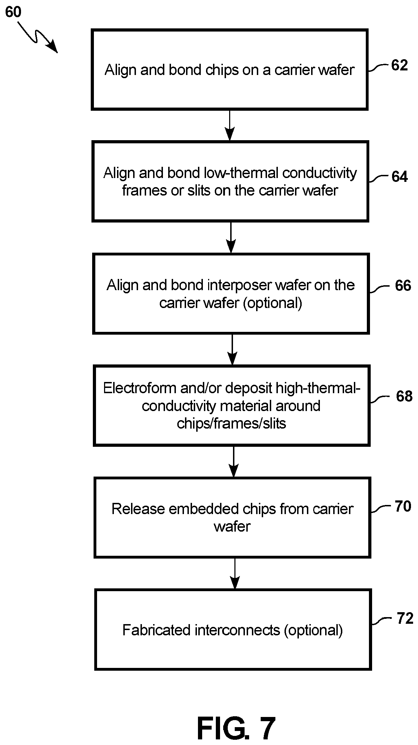

. Other embodiments of this presentation relate to a method of manufacturing an electronic assembly, comprising: providing a first component chip having a first component chip top surface, a first component chip bottom surface and first component chip side surfaces; said first component chip comprising at least one first component contact pad on said first component chip top surface; providing a second component chip having a second component chip top surface, a second component chip bottom surface and second component chip side surfaces; said second component chip comprising at least one second component contact pad on said second component chip top surface; providing a handle wafer having a first surface; attaching said first and second component chips top surfaces to said first surface of said handle wafer; providing a carrier wafer having a top wafer surface and a bottom wafer surface; forming in the carrier wafer an electronic integrated circuit having first and second integrated circuit contact pads on the top wafer surface; forming in the carrier wafer a through-wafer cavity having walls that join said top wafer surface to said bottom wafer surface; attaching said top wafer surface to said first surface of said handle wafer such that said first and second component chips are arranged within said through-wafer cavity; positioning a barrier structure having a heat conductivity lower than a heat conductivity of said carrier wafer in said through-wafer cavity between the first and second component chips; filling at least a portion of said through-wafer cavity with an heat conducting attachment material so as to hold the first and second component chips in said through-wafer cavity by direct contact of at least a side surface of said first and second component chips with said heat conducting attachment material and so as to hold said barrier structure between the first and second component chips by direct contact with said heat conducting attachment material; detaching the handle wafer from the first and second component chips top surface and the top wafer surface; and at least one of forming a first conductor between the first integrated circuit contact pad and said first component contact pad; and forming a second conductor between the second integrated circuit contact pad and said second component contact pad. According to an embodiment of said presentation, said positioning a barrier structure having a heat conductivity lower than a heat conductivity of said carrier wafer in said through-wafer cavity between the first and second component chips comprises attaching the barrier structure to said first surface of said handle wafer and/ or to at least a wall of said through-wafer cavity. Such embodiments are for example illustrated in Figure 7.

. According to embodiments of this presentation, said filling at least a portion of said through-cavity with said heat conducting attachment material comprises depositing said heat conducting attachment material by electroplating. Such embodiments are for example illustrated in Figure 7.

. According to embodiments of this presentation, the barrier is arranged parallel to at least two side surfaces of one of the first and second component chips.

. According to embodiments of this presentation, the barrier surrounds one of the first and second chips.

. According to embodiments of this presentation, the positioning of the barrier structure between the first and second component chips comprises positioning a sacrificial structure between the first and second component chips which can be removed, after said filling at least a portion of said through-wafer cavity with an attachment material, to provide a barrier structure made out of air.

. Another embodiment of this presentation comprises an electronic assembly, having a carrier wafer with a top wafer surface and a bottom wafer surface; an electronic integrated circuit being formed in the carrier wafer and comprising first and second integrated circuit contact pads; said carrier wafer comprising a through-wafer cavity having walls that join said top wafer surface to said bottom wafer surface; first and second component chips held in said through-wafer cavity each by direct contact of at least a side surface of said first and second component chips with a heat conducting attachment material that fills said through-wafer cavity; said first and second component chips comprising respectively at least a first and a second component contact pads; a barrier having a heat conductivity lower than a heat conductivity of said carrier wafer held by said heat conducting attachment material in said through-wafer cavity between said first and said second component chips.

### FIGURES

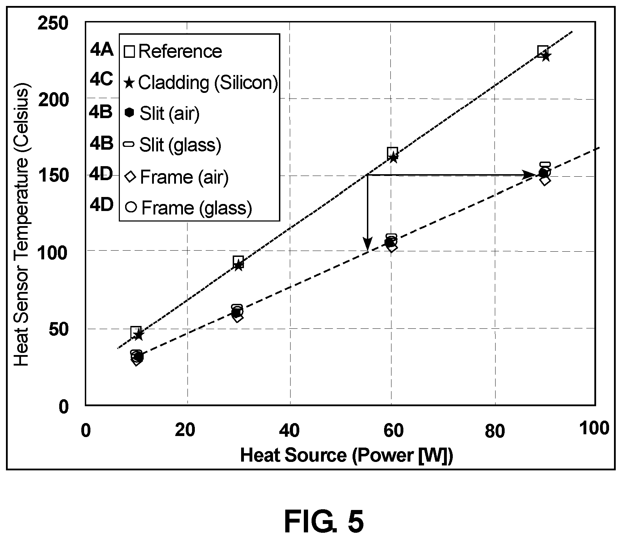

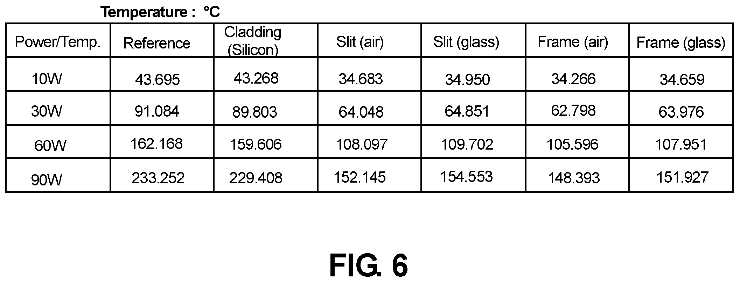

. The above features will now be described in more details in relation with the following figures, wherein:
. Figures 1A and 1B illustrate a cross section and a top view of a known assembly.
. Figures 2A and 2B illustrate a cross section and a top view of an assembly according to an embodiment of this presentation.
. Figures 3A and 3B illustrate a cross section and a top view of an assembly according to another embodiment of this presentation.
. Figures 4A to 4D illustrate a top view of two simulated assembly embodiments of this presentation as well as two reference assemblies.
. Figure 5 is a graph illustrating the results of the simulation of the assemblies in Figures 4A-D.
. Figure 6 is a table showing the results in Figure 5.
. Figure 7 illustrates a method according to an embodiment of this presentation.

### DETAILED DESCRIPTION

. The following description is presented to enable one of ordinary skill in the art to make and use the teachings of this presentation and to incorporate them in the context of particular applications.

. In the following detailed description, numerous specific details are set forth in order to provide a more thorough understanding of embodiments of this presentation. However, it will be apparent to one skilled in the art that such embodiments may be practiced without necessarily being limited to these specilic details.

. All the features disclosed in this presentatoin, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

. An electronic assembly according to embodiments of this presentation integrates high-performance integrated circuits, such as GaN RF MMICs, into carrier wafers having integrated circuits, such as silicon-based integrated circuits, in a manner that is inexpensive and has high manufacturing yields and short manufacturing cycles.

. According to embodiments of this presentation, the high performance integrated circuit or component can comprise III-V transistors or integrated circuits and they can be integrated, eventually together with resistors, inductors, capacitors and matching networks, into the carrier wafers.

. Generally, embodiments of this presentation comprise an apparatus / assembly with one or more chips held by an heat conducting attachment material in a through-wafer cavity of a carrier wafer, said apparatus having all the features of an apparatus / assembly as described in US Patent No. 10998273. Additionally, at least one low-thermal conductivity component, or barrier, is arranged in the cavity between two of the chips held by the metal. This allows thermally isolating the two chips and thus mitigating thermal crosstalk between the two chips. As such, the metal-held chips benefit from the intimate contact with the heat conducting attachment material, which operates as a high-thermal conductivity heat spreader, but without being heated by neighboring chips. Alternatively, or additionally, the barrier can be arranged in the cavity between one chip held by the metal and a wall of the cavity to mitigate thermal crosstalk between the chip and the carrier wafer (which itself can comprise one or more integrated cictuits). According to some embodiments of this presentation, the barrier can surround the chip to be isolated. The barrier can have a height identical to the height of the cavity. The cavity can comprise a single chip held in metal, the barrier isolating at least one side of the chip from a wall of the cavity.

. Overall, embodiments of this presentation provide an additional thermal isolation of chips or modules otherwise embedded in metal as disclosed in US Patent No. 10998273, while maintaining a core feature of such metal embedding (the metal acting as a thermal heat spreader). Multi-chip modules as disclosed in US Patent No. 10998273 may comprise at least one metal-held high power chip (which dissipates a lot of heat) next to a lower power metal-held chip (which dissipates less heat than its neighbor). While the metal holding the high-power chip provides a tool to operate the high-power chip more efficiently, the heat generated by the high-power chip may nevertheless affect negatively the neighbor lower power chip through thermal cross talk (due to the high thermal conductivity of the embedding metal). Embodiments of this presentation provide the advantage of holding the chips in metal while providing thermal isolation between chips.

. Embodiments of this presentation also comprise methods of manufacturing the electronic assemblies described above. Such methods can comprise all the steps of the methods disclosed in US Patent No. 10998273, and additionally comprise steps for providing at least one barrier between two chips held in metal (or between one chip held in metal and the walls of the cavity filled with metal).
A "MECA" technology (Metal Embedded Chip Assembly) such as disclosed in disclosed in US Patent No. 10998273 co-integrates multiple chips into compact modules with integrated heat spreaders and interconnects (Figure 1). While such technology has proven to improve thermal dissipation by providing direct contact between the chip and a high-thermal conductivity heat spreader (e.g., electroplated copper), as shown in Figures 1A and 1B, described above, such technology does not address thermal cross-talk between chips. In some cases, one can find low-power chips next to high-power chips, and the high-power chip can potentially heat up the low-power chip, impacting negatively the performance of the low-power chip.

. To address this crosstalk issue, this presentation provides for adding at least one low-thermal-conductivity spacer or barrier into the "MECA" modules. Figures 2A and 2B illustrate an exemplary embodiment of an assembly 30 according to this presentation using a "slit" concept between the metal-held chips 18, 18', where a thermal barrier 32 is embodied by a slit filled with a material having a conductivity lower than the conductivity of the carrier wafer material (for example with air or glass, in particular in case the carrier wafer is Silicon). Figures 2A and 2B are identical with Figures 1A and 1B, respectively, except that thermal barrier 32 is arranged in metal 20 between the component chips 18, 18'. As illustrated in Figures 2A, 2B, an embodiment of this presentation comprises an electronic assembly 30 having a carrier wafer 12 with a top wafer surface 12' and a bottom wafer surface 12"; an electronic integrated circuit 14, 14' being formed in the carrier wafer 12 and comprising first (15) and second (15') integrated circuit contact pads on one of the top wafer surface and the bottom wafer surface (top wafer surface illustrated); said carrier wafer 12 comprising a through-wafer cavity 16 having walls 16' that join said top wafer surface 12' to said bottom wafer surface 12".

. According to embodiments of this presentation, assembly 30 further comprises a first component chip 18 with a first component chip top surface, a first component chip bottom surface and first component chip side surfaces, the first component chip 18 being held in said through-wafer cavity 16 by direct contact of at least a side surface of said first component chip 18 with a heat conducting attachment material 20 (e.g. a metal) that fills at least a portion of said through-wafer cavity 16; said first component chip 18 comprising at least one first component contact pad 19 on one of said first component chip top surface and said first component chip bottom surface (top surface illustrated); a second component chip 18' with a second component chip top surface, a second component chip bottom surface and second component chip side surfaces, the second component chip 18' being held in said through-wafer cavity 16 by direct contact of at least a side surface of said second component chip 18' with said heat conducting attachment material 20; said second component chip 18' comprising at least one second component contact pad 19' on one of said second component chip top surface and said second component chip bottom surface; wherein a barrier 32 having a heat conductivity lower than a heat conductivity of said carrier 12 wafer (and also lower than a heat conductivity of the material 20) is held by said heat conducting attachment material 20 in said through-wafer cavity 16 between said first and said second component chips 18 and 18'.

. Two component chips 18, 18' are illustrated in Figures 2A, 2B but more than two component chips can be embedded in material 20, for example with a barrier 32 between each of the component chips to prevent thermal cross talk between said component chips. According to embodiments of this presentation, a first conductor 22 can connect the first integrated circuit contact pad 15 and the first component contact pad 19; and/or a second conductor 22' can connect the second integrated circuit contact pad 15' and the second component contact pad 19'.

. According to an embodiment of this presentation, the first component chip 18 and second component chip 18' have first and second heights H1 and H2 and the barrier 32 has a barrier height Hb at least as large as the smallest of the first and second heights H1, H2. According to an embodiment of this presentation, the through-wafer cavity 16 has a cavity height Hc and the barrier height Hb is equal to the cavity height Hc.

. According to an embodiment of this presentation, and as shown for example in Figure 2B, the first and second component chips 18, 18' have each a side closest to the barrier 32 that have first and second lengths L1, L2, and the barrier 32 has a barrier length Lb at least as large as the smallest of said first and second lengths L1, L2. According to an embodiment, the through-wafer cavity 16 has a cavity length Lc and the barrier length is equal to the cavity length.

. In the illustration of Figure 2B, the barrier has a length such that the barrier extends from wall to wall in the cavity. The barrier however can have a smaller length.

. According to an embodiment of this presentation, the barrier 32 has a thickness Tb at least equal to one fifth of the distance between the first component chip 18 and the second component chip 18'.

. As illustrated in Figure 2A, the heat conducting attachment material 20 can hold the first and second component chips (18, 18') such that the first and second component chips top surfaces are flush with the top wafer surface. According to an embodiment of this presentation, the walls 16' of the through-wafer cavity 16 are covered with a dielectric layer 17 having a material and a thickness chosen to electrically insulate material 20 from the integrated circuits 14, 14' in carrier wafer 12.

. According to an embodiment of this presentation, the attachment material 20 can contact less than half of the side surfaces of each of the first and second component chips (18, 18'). However, as illustrated in Figures 2A, 2B, attachment material 20 preferably contacts more than half of the side surfaces of the first and second component chips (18, 18'). The carrier wafer 12 and at least the first or second component chips 18, 18' can be made of different materials. At least one of the first and second component chips 18, 18' can be an integrated circuit chip comprising one or more transistors (the transistors are not shown).

. Figures 3A and 3B illustrate an exemplary embodiment of an assembly 40 according to this presentation using a "frame" concept where a heat-producing chip (18) is surrounded by a barrier 42 of a material having a conductivity lower than the conductivity of the carrier wafer material 12 (for example with air or glass, in particular in case the carrier wafer is Silicon). Figures 3A and 3B are identical to Figures 2A and 2B, except that the single-wall barrier 32 of Figures 2A and 2B is replaced by a multiple-walls barrier 42 (barrier 42 has four walls in Figures 3A and 3B and surrounds completely component chip 18, but according to some embodiments, barrier 42 can comprise only two walls or more and surround only partially chip 18). Only one barrier 42 is illustrated in Figures 3A and 3B around one chip 18, but assembly 40 can comprise one or more chips 18 surrounded each by one or more barriers 42.

. In case the barrier 42 is as high as the cavity 16, barrier 42 may be filled by a solid material such as glass or ceramic. A "frame" barrier 42 allows forming an individual heat spreader with low thermal cross-talk around heat-producing chips. The walls of the "frame" barrier 42 can have the same length and height as in Figures 2A and 2B. As illustrated in Figures 3A/3B, a metal layer 44 can cover at least a portion of the bottom surface of the carrier wafer 12 as well as at least a portion of the bottom surface of the material 20 (e.g. metal) that fills the carrier wafer cavity 16, thus facilitating heat evacuation by the material 20 in the cavity 16. Advantageously, when such a metal layer 44 is present, it can hold together the portions of material 20 that lie on both sides of barrier 42, in particular in case barrier 42 is filled with a non solid material such as air.

. In an example where the chips were 100 um apart, the inventor modeled glass (and air) slits/barrier 32 that are 20 um wide (and 300 um high, which can be the same height as the cavity). Two exemplary embodiments 30, 40 of this presentation that were subject to a simulation by the Inventor are illustrated in Figures 4B and 4D. Each embodiment comprises two chips 18, 18' that have each a surface of 0.5 x 0.5 mm, separated by a distance of 100 um, and both embedded in a metal 20 (copper) in a same 300 um - deep cavity 16. The chips 18, 18' were chosen to mimic RF GaN integrated circuits having transistors. In these chips, the heat is generated mainly by the area of the transistors. The Inventor simulated a heat source 54 on one chip (18), and a heat sensor 56 (or thermal sensor) on the other chip (18') to measure the cross talk between chips. In particular, the dissipated power from one chip was scaled to match high power densities observed in GaN MMICs. In particular, the second chip contained a thermal sensor where the peak temperature is tracked as a function of the power dissipated in the first chip. The simulation was performed in a steady state. The backside of the assembly was held at 25 C. Power was applied to the heat source 54 and temperature was measured in the thermal sensor 56. A first reference model 10, illustrated in Figure 4A, was also simulated. The first reference model 10 consists of the 2 chips 18, 18' as detailed above embedded in the copper 20. No low-thermal conductivity component / barrier 32 or 42 was embedded in the metal 20 between the chips 18, 18' of the reference model 10. A second reference model 10', illustrated in Figure 4C, was also simulated. In the second reference model the 2 chips 18. 18' detailed above are embedded in metal 20, 20' each in a different cavity 16, 16' of the carrier wafer separated by a portion 12' of the carrier wafer 12. The embodiment in Figure 4B uses a slit design where the chips 18, 18' are separated by a low-thermal-conductivity component /barrier 32 (glass and air barriers were simulated). The slit that forms barrier 32 can be of any shape for modules with more than 2 chips. According to an embodiment, the barrier 32 can comprise at least two walls arranged each parallel to a different side surface of one of the first and second component chips. The embodiment of Figure 4D uses a low-thermal-conductivity frame / barrier 42 around the power chip 18 to thermally isolate it from the rest of the module / assembly 40. The results of the simulations are plotted in Figure 5 and summarized in Figure 6. It appears that in the case where each chip is in a separate cavity (or "silicon cladding" case), there is only negligible thermal isolation. Indeed, the measured temperature on the thermal sensor chip in this configuration is comparable to the measured temperature on the thermal sensor chip in the reference configuration. This is expected since the silicon of the carrier wafer has a reasonably high thermal conductivity (100 W/mK). Figure 5 illustrates the results of the simulations for Figures 4A to 4D. Two simulations (one for an air barrier, one for a glass barrier) were conducted for each of Figures 4B and 4D. The silicon cladding provides negligible thermal isolation when compared against the reference module. This is to be expected since the thermal conductivity of silicon is ~ 100 W/mK to 350-400 W/mK for a copper heat spreader. However, both the air/glass slits and frames provide a significant reduction in thermal cross-talk. Glass slits and frames provide nearly the same thermal isolation as air. Figure 5 shows that the embodiments of this presentation in Figures 4B and 4D, with glass and air slit and glass and air frame barriers, show significant reduction in the temperature measured on the thermal sensor chip. Figure 5 also shows that the frame design, in Figure 4D, provides slightly better thermal isolation since it fully encloses the high-power chip 18.

. As an example, the thermal isolation design provides a reduction in peak temperature of 50C at 55W of input power (from 150C for the reference model, down to 100 C for a thermally-isolated MECA package). Conversely, at 150C of peak temperature in the sensor chip, one can dissipate nearly twice as much power in the power chip (from 55W to 90W). These results have significant impact for a module subsystem - either by increasing the performance (more power for the same temperature), or by increasing reliability.

. While the air configuration is a better thermal solution, it is more challenging to manufacture. Therefore, a preferred approach to an air barrier is a glass barrier or frame. Figure 6 summarises in a table the data from Figure 5

. Figure 7 illustrates a process flow method 60 according to embodiments of this presentation. In this embodiment, the assembly will comprise at least two chips 18, 18' held in a metal 20 with at least one side of each chip in direct contact with metal 20, the chips being separated with at least one low-thermal conductivity component/barrier 32, 42. According to a preferred embodiment, the low-thermal conductivity component/barrier 32, 42 is at least the same height as the integrated metallic heat spreader 20, and has preferably a length as large as the smallest of the facing lengths of the chips 18, 18'.

. Method 60 comprises: at step 62, providing a first component chip having a first component chip top surface, a first component chip bottom surface and first component chip side surfaces; said first component chip comprising at least one first component contact pad on said first component chip top surface; providing a second component chip having a second component chip top surface, a second component chip bottom surface and second component chip side surfaces; said second component chip comprising at least one second component contact pad on said second component chip top surface; providing a handle wafer having a first surface, and attaching (aligning and bonding) said first and second component chips top surfaces to said first surface of said handle wafer.

. At step 64, positioning (aligning and bonding) a barrier structure having a heat conductivity lower than a heat conductivity of a carrier wafer in said through-wafer cavity between the first and second component chips.

. At step 66, providing a carrier wafer having a top wafer surface and a bottom wafer surface; forming in the carrier wafer an electronic integrated circuit having first and second integrated circuit contact pads on the top wafer surface; forming in the carrier wafer a through-wafer cavity having walls that join said top wafer surface to said bottom wafer surface; attaching (aligning and bonding) said top wafer surface to said first surface of said handle wafer such that said first and second component chips are arranged within said through-wafer cavity. It is to be noted that steps 62, 64, 66 are not necessarily implemented in the order described above.

. At step 68, filling (by electroforming or metal deposition) at least a portion of said through-wafer cavity with a heat conducting attachment material so as to hold the first and second component chips in said through-wafer cavity by direct contact of at least a side surface of said first and second component chips with said heat conducting attachment material and so as to hold said barrier structure between the first and second component chips by direct contact with said heat conducting attachment material;

. At step 70, detaching the handle wafer from the first and second component chips top surface and the top wafer surface.

. At step 72, at least one of: forming a first conductor between the first integrated circuit contact pad and said first component contact pad; and forming a second conductor between the second integrated circuit contact pad and said second component contact pad.

. Having now described the invention in accordance with the requirements of the patent statutes, those skilled in this art will understand how to make changes and modifications to the present invention to meet their specific requirements or conditions.

. It is to be noted that a step of pre-fabricating "thermal isolation" or low-thermal conductivity frames or slits/walls based on module design can be implemented prior to the step of aligning and bonding said frames or slits on the carrier wafer. In an example, a frame is made of glass and to produce a structure such as illustrated in Fig. 4D, one can form a glass frame that is of the order of 700 um wide, 700 um long, and 300 um tall, with a sidewall that is 20 um thick. Such a glass frame is for example manufacturable using laser micromachining. Another way is to reflow glass into high-aspect ratio silicon-etched molds, and then remove the silicon, for example using XeF2 etch. See for example the paper entitled: "Capabilities and Limits to Form High Aspect-Ratio Microstructures by Molding of Borosilicate Glass" by Amid Amnache et al.; Journal of Microelectromechanical Systems (Volume: 28, Issue: 3, June 2019), Page(s): 432-440; Print ISSN: 1057-7157; Electronic ISSN: 1941-0158.

. In order to pick-and-place the frame or wall accurately on the carrier wafer, the frame or wall can be temporarily bonded onto a tape or other holding structure that allows for e.g. vacuum pick, as can be done with small chips. The frame or wall can then be bonded to the carrier wafer in a same way as the chips can be bonded according to this presentation, for example by adhesive bonding the frame or wall, and then electroplating around it.

. It is noted that producing a structure such as illustrated in Fig. 4B could for example require a glass "slit" or wall to be of the order of 1000 um long, 300 um tall, and 20 um thick. The inventor has noted that it is possible to make such a slit/wall stand on end when placed on its side on tape.

. Finally, it is noted that the process of Fig. 7 does not address fully the case when the frame or slit of Fig. 4 consists of air. Such embodiments can be manufactured the same way as with a glass frame or wall as in Figure 7, but with additional steps to selectively etch the glass after forming the metal embedding/ the electroforming step.

. The foregoing Detailed Description of exemplary and preferred embodiments is presented for purposes of illustration and disclosure in accordance with the requirements of the law.

## Claims

1. An electronic assembly (30), having:
a carrier wafer (12) with a top wafer surface (12') and a bottom wafer surface (12");
an electronic integrated circuit (14, 14') being formed in the carrier wafer (12) and comprising first (15) and second (15') integrated circuit contact pads on at least one of the top wafer surface (12') and the bottom wafer surface (12"); said carrier wafer (12) comprising a through-wafer cavity (16) having walls (16') that join said top wafer surface (12') to said bottom wafer surface (12");
a first component chip (18)with a first component chip top surface, a first component chip bottom surface and first component chip side surfaces, the first component chip (18) being held in said through-wafer cavity (16) by direct contact of at least a side surface of said first component chip (18) with a heat conducting attachment material (20) that fills at least a portion of said through-wafer cavity (16); said first component chip (18) comprising at least one first component contact pad (19) on at least one of said first component chip top surface and said first component chip bottom surface;
a second component chip (18') with a second component chip top surface, a second component chip bottom surface and second component chip side surfaces, the second component chip (18') being held in said through-wafer cavity (16) by direct contact of at least a side surface of said second component chip (18') with said heat conducting attachment material (20); said second component chip (18') comprising at least one second component contact pad (19') on at least one of said second component chip top surface and said second component chip bottom surface;
wherein a barrier (32; 42) having a heat conductivity lower than a heat conductivity of said carrier wafer (12) is held by said heat conducting attachment material (20) in said through-wafer cavity (16) between said first (18) and said second (18')component chips;
and having at least one of:
a first conductor (22) connecting said first integrated circuit contact pad (15) and said first component contact pad (19); and
a second conductor (22') connecting said second integrated circuit contact pad (15') and said second component contact pad (19').

2. The assembly of claim 1, wherein, the first (18) and second (18') component chips have first and second heights and the barrier (32; 42) has a barrier height at least as large as the smallest of the first and second heights; or wherein, the through-wafer cavity (16) has a cavity height and the barrier height is equal to the cavity height.

3. The assembly of claim 1, wherein the first (18) and second (18') component chips have each a side closest to the barrier (32, 42) that have first and second lengths, and wherein the barrier (32, 42) has a barrier length at least as large as the smallest of said first and second lengths; or wherein, the through-wafer cavity (16) has a cavity length and the barrier length is equal to the cavity length.

4. The assembly of claim 1, wherein the barrier material comprises one of air, ceramic and glass.

5. The assembly of claim 1, wherein the barrier (32, 42) has a thickness equal to one fifth or more of a distance between the first (18) and second (18') component chips.

6. The assembly of claim 1, wherein the heat conducting attachment material (20) holds the first (18) and second (18') component chips such that the first (18) and second (18') component chips top surfaces are flush with the top wafer surface (12').

7. The assembly of claim 1, wherein a metal layer (44) covers at least a portion of the bottom wafer surface (12") as well as the heat conducting attachment material (20) in the through-wafer cavity (16).

8. The assembly of claim 1, wherein the walls (16') of the through-wafer cavity (16) are covered with a dielectric layer (17).

9. The assembly of claim 1, wherein at least one of the first (18) and second (18') component chips is an integrated circuit chip comprising one or more transistors.

10. The assembly of claim 1, wherein the carrier wafer (12) and at least one of the first (18) and second (18') component chips have a different height.

11. A method of manufacturing an electronic assembly, the method comprising: providing a first component chip (18) having a first component chip top surface, a first component chip bottom surface and first component chip side surfaces; said first component chip (18) comprising at least one first component contact pad (19) on said first component chip top surface;
providing a second component chip (18') having a second component chip top surface, a second component chip bottom surface and second component chip side surfaces; said second component chip comprising at least one second component contact pad (19') on said second component chip top surface;
providing a handle wafer having a first surface, and attaching said first (18) and second (18') component chips top surfaces to said first surface of said handle wafer;
providing a carrier wafer (12) having a top wafer surface (12') and a bottom wafer surface (12"); forming in the carrier wafer (12) an electronic integrated circuit (14, 14') having first (15) and second (15') integrated circuit contact pads on the top wafer surface (12'); forming in the carrier wafer (12) a through-wafer cavity (16) having walls (16') that join said top wafer surface (12') to said bottom wafer surface (12");
attaching said top wafer surface (12') to said first surface of said handle wafer such that said first (18) and second (18') component chips are arranged within said through-wafer cavity (16);
positioning a barrier structure (32, 42) having a heat conductivity lower than a heat conductivity of said carrier wafer (12) in said through-wafer cavity (16) between the first (18) and second (18') component chips;
filling at least a portion of said through-wafer cavity (16) with a heat conducting attachment material (20) so as to hold the first (18) and second (18') component chips in said through-wafer cavity (16) by direct contact of at least a side surface of said first (18) and second (18') component chips with said heat conducting attachment material (20) and so as to hold said barrier structure (32, 42) between the first (18) and second (18') component chips by direct contact with said heat conducting attachment material (20);
detaching the handle wafer from the first (18) and second (18') component chips top surface and the top wafer surface (12'); and
at least one of:
forming a first conductor (22) between the first integrated circuit contact pad (15) and said first component contact pad (19); and
forming a second conductor (22') between the second integrated circuit contact pad (15') and said second component contact pad (19').

12. The assembly of claim 1 or the method of claim 11, wherein said heat conducting attachment material (20) is a metal.

13. The method of claim 11, wherein said positioning a barrier structure (32, 42) having a heat conductivity lower than a heat conductivity of said carrier wafer (12) in said through-wafer cavity (16) between the first (18) and second (18') component chips comprises attaching the barrier structure (32, 42) to said first surface of said handle wafer and/ or to at least a wall (16') of said through-wafer cavity (16); or wherein said positioning a barrier structure (32) between the first (18) and second (18') component chips comprises positioning a sacrificial structure between the first (18) and second (18') component chips which can be removed, after said filling at least a portion of said through-wafer cavity (16) with a heat conducting attachment material (20), to provide a barrier structure (32) made out of air.

14. The method of claim 12, wherein said filling at least a portion of said through-wafer cavity (16) with said metal (20) comprises depositing said metal by electroplating.

15. The apparatus of claim 1 or the method of claim 11, wherein the barrier structure (32, 42) comprises two walls arranged each parallel to a different side surface of one of the first (18) and second (18') component chips; or
wherein the barrier structure (42) surrounds one of the first (18) and second (18') chips.

## Patentansprüche

1. Elektronische Baugruppe (30), die aufweist:
einen Trägerwafer (12) mit einer oberen Waferoberfläche (12') und einer unteren Waferoberfläche (12");
eine elektronische integrierte Schaltung (14, 14'), die in dem Trägerwafer (12) ausgebildet ist und erste (15) und zweite (15') Kontaktflächen der integrierten Schaltung auf mindestens einer der oberen Waferoberfläche (12') und der unteren Waferoberfläche (12") aufweist;
wobei der Trägerwafer (12) einen durch den Wafer hindurchgehenden Hohlraum (16) mit Wänden (16') aufweist, die die obere Waferoberfläche (12') mit der unteren Waferoberfläche (12") verbinden;
einen ersten Komponenten-Chip (18) mit einer oberen Oberfläche des ersten Komponenten-Chips, einer unteren Oberfläche des ersten Komponenten-Chips und Seitenflächen des ersten Komponenten-Chips, wobei der erste Komponenten-Chip (18) in dem durch den Wafer hindurchgehenden Hohlraum (16) durch direkten Kontakt mindestens einer Seitenfläche des ersten Komponenten-Chips (18) mit einem wärmeleitenden Befestigungsmaterial (20) gehalten wird, das mindestens einen Teil des durch den Wafer hindurchgehenden Hohlraums (16) ausfüllt; wobei der erste Komponenten-Chip (18) mindestens eine erste Komponenten-Kontaktfläche (19) auf mindestens einer der oberen Oberfläche des ersten Komponenten-Chips und der unteren Oberfläche des ersten Komponenten-Chips aufweist;
einen zweiten Komponenten-Chip (18') mit einer oberen Oberfläche des zweiten Komponenten-Chips, einer unteren Oberfläche des zweiten Komponenten-Chips und Seitenflächen des zweiten Komponenten-Chips, wobei der zweite Komponenten-Chip (18') in dem durch den Wafer hindurchgehenden Hohlraum (16) durch direkten Kontakt mindestens einer Seitenfläche des zweiten Komponenten-Chips (18') mit dem wärmeleitenden Befestigungsmaterial (20) gehalten wird; wobei der zweite Komponenten-Chip (18') mindestens eine zweite Komponenten-Kontaktfläche (19') auf mindestens einer der oberen Oberfläche des zweiten Komponenten-Chips und der unteren Oberfläche des zweiten Komponenten-Chips aufweist;
wobei eine Barriere (32; 42), die eine geringere Wärmeleitfähigkeit als der Trägerwafer (12) aufweist, durch das wärmeleitende Befestigungsmaterial (20) in dem durch den Wafer hindurchgehenden Hohlraum (16) zwischen dem ersten (18) und dem zweiten (18') Komponenten-Chip gehalten wird;
und mindestens eines aus Folgendem aufweist:
einen ersten Leiter (22), der die erste Kontaktfläche der integrierten Schaltung (15) und die erste Komponenten-Kontaktfläche (19) verbindet; und
einen zweiten Leiter (22'), der die zweite Kontaktfläche der integrierten Schaltung (15') und die zweite Komponenten-Kontaktfläche (19') verbindet.

2. Baugruppe nach Anspruch 1, wobei der erste (18) und der zweite (18') Komponenten-Chip eine erste und eine zweite Höhe aufweisen und die Barriere (32, 42) eine Barrierenhöhe aufweist, die mindestens so groß ist wie die kleinere der ersten und zweiten Höhe; oder wobei der durch den Wafer hindurchgehende Hohlraum (16) eine Hohlraumhöhe aufweist und die Barrierenhöhe gleich der Hohlraumhöhe ist.

3. Baugruppe nach Anspruch 1, wobei der erste (18) und der zweite (18') Komponenten-Chip jeweils eine der Barriere (32, 42) zugewandte Seite aufweisen, die eine erste und zweite Länge aufweist, und wobei die Barriere (32, 42) eine Barrierenlänge aufweist, die mindestens so groß ist wie die kleinere der ersten und zweiten Länge; oder wobei der durch den Wafer hindurchgehende Hohlraum (16) eine Hohlraumlänge aufweist und die Barrierenlänge gleich der Hohlraumlänge ist.

4. Die Baugruppe nach Anspruch 1, wobei das Barrierenmaterial eines von Luft, Keramik und Glas umfasst.

5. Baugruppe nach Anspruch 1, wobei die Barriere (32, 42) eine Dicke aufweist, die einem Fünftel oder mehr eines Abstands zwischen dem ersten (18) und dem zweiten (18') Komponenten-Chip entspricht.

6. Baugruppe nach Anspruch 1, wobei das wärmeleitende Befestigungsmaterial (20) den ersten (18) und den zweiten (18') Komponenten-Chip so hält, dass die oberen Oberflächen des ersten (18) und des zweiten (18') Komponenten-Chips bündig mit der oberen Waferoberfläche (12') sind.

7. Baugruppe nach Anspruch 1, wobei eine Metallschicht (44) mindestens einen Teil der unteren Waferoberfläche (12") sowie das wärmeleitende Befestigungsmaterial (20) in dem durch den Wafer hindurchgehenden Hohlraum (16) bedeckt.

8. Baugruppe nach Anspruch 1, wobei die Wände (16') des durch den Wafer hindurchgehenden Hohlraums (16) mit einer dielektrischen Schicht (17) bedeckt sind.

9. Baugruppe nach Anspruch 1, wobei mindestens einer des ersten (18) und des zweiten (18') Komponenten-Chips ein integrierter Schaltungschip ist, der einen oder mehrere Transistoren umfasst.

10. Baugruppe nach Anspruch 1, wobei der Trägerwafer (12) und mindestens einer des ersten (18) und des zweiten (18') Komponenten-Chips eine unterschiedliche Höhe aufweisen.

11. Verfahren zum Herstellen einer elektronischen Baugruppe, das Verfahren umfassend:
Bereitstellen eines ersten Komponenten-Chips (18) mit einer oberen Oberfläche des ersten Komponenten-Chips, einer unteren Oberfläche des ersten Komponenten-Chips und Seitenflächen des ersten Komponenten-Chips; wobei der erste Komponenten-Chip (18) mindestens eine erste Komponenten-Kontaktfläche (19) auf der oberen Oberfläche des ersten Komponenten-Chips aufweist;
Bereitstellen eines zweiten Komponenten-Chips (18') mit einer oberen Oberfläche des zweiten Komponenten-Chips, einer unteren Oberfläche des zweiten Komponenten-Chips und Seitenflächen des zweiten Komponenten-Chips; wobei der zweite Komponenten-Chip mindestens eine zweite Komponenten-Kontaktfläche (19') auf der oberen Oberfläche des zweiten Komponenten-Chips aufweist;
Bereitstellen eines Handhabungswafers mit einer ersten Oberfläche und Anbringen der oberen Oberflächen des ersten (18) und des zweiten (18') Komponenten-Chips an der ersten Oberfläche des Handhabungswafers;
Bereitstellen eines Trägerwafers (12) mit einer oberen Waferoberfläche (12') und einer unteren Waferoberfläche (12"); Ausbilden einer elektronischen integrierten Schaltung (14, 14') in dem Trägerwafer (12), die erste (15) und zweite (15') Kontaktflächen der integrierten Schaltung auf der oberen Waferoberfläche (12') aufweist; Ausbilden eines durch den Wafer hindurchgehenden Hohlraums (16) in dem Trägerwafer (12), der Wände (16') aufweist, die die obere Waferoberfläche (12') mit der unteren Waferoberfläche (12") verbinden;
Anbringen der oberen Waferoberfläche (12') an der ersten Oberfläche des Handhabungswafers, sodass der erste (18) und der zweite (18') Komponenten-Chip innerhalb des durch den Wafer hindurchgehenden Hohlraums (16) angeordnet sind;
Positionieren einer Barrierenstruktur (32, 42), die eine geringere Wärmeleitfähigkeit als der Trägerwafer (12) aufweist, in dem durch den Wafer hindurchgehenden Hohlraum (16) zwischen dem ersten (18) und dem zweiten (18') Komponenten-Chip;
Füllen mindestens eines Teils des durch den Wafer hindurchgehenden Hohlraums (16) mit einem wärmeleitenden Befestigungsmaterial (20), um den ersten (18) und den zweiten (18') Komponenten-Chip in dem durch den Wafer hindurchgehenden Hohlraum (16) durch direkten Kontakt mindestens einer Seitenfläche des ersten (18) und des zweiten (18') Komponenten-Chips mit dem wärmeleitenden Befestigungsmaterial (20) zu halten und um die Barrierenstruktur (32, 42) zwischen dem ersten (18) und dem zweiten (18') Komponenten-Chip durch direkten Kontakt mit dem wärmeleitenden Befestigungsmaterial (20) zu halten;
Ablösen des Handhabungswafers von der oberen Oberfläche des ersten (18) und des zweiten (18') Komponenten-Chips und von der oberen Waferoberfläche (12'); und
mindestens eines von:
Ausbilden eines ersten Leiters (22) zwischen der ersten Kontaktfläche der integrierten Schaltung (15) und der ersten Komponenten-Kontaktfläche (19); und
Ausbilden eines zweiten Leiters (22') zwischen der zweiten Kontaktfläche der integrierten Schaltung (15') und der zweiten Komponenten-Kontaktfläche (19').

12. Baugruppe nach Anspruch 1 oder Verfahren nach Anspruch 11, wobei das wärmeleitende Befestigungsmaterial (20) ein Metall ist.

13. Verfahren nach Anspruch 11, wobei das Positionieren einer Barrierenstruktur (32, 42), die eine geringere Wärmeleitfähigkeit als der Trägerwafer (12) aufweist, in dem durch den Wafer hindurchgehenden Hohlraum (16) zwischen dem ersten (18) und dem zweiten (18') Komponenten-Chip das Anbringen der Barrierenstruktur (32, 42) an der ersten Oberfläche des Handhabungswafers und/oder an mindestens einer Wand (16') des durch den Wafer hindurchgehenden Hohlraums (16) umfasst; oder
wobei das Positionieren einer Barrierenstruktur (32) zwischen dem ersten (18) und dem zweiten (18') Komponenten-Chip das Positionieren einer Opferstruktur zwischen dem ersten (18) und dem zweiten (18') Komponenten-Chip umfasst, die nach dem Füllen mindestens eines Teils des durch den Wafer hindurchgehenden Hohlraums (16) mit einem wärmeleitenden Befestigungsmaterial (20) entfernt werden kann, um eine aus Luft bestehende Barrierenstruktur (32) bereitzustellen.

14. Verfahren nach Anspruch 12, wobei das Füllen mindestens eines Teils des durch den Wafer hindurchgehenden Hohlraums (16) mit dem Metall (20) das Abscheiden des Metalls durch galvanisches Beschichten umfasst.

15. Vorrichtung nach Anspruch 1 oder Verfahren nach Anspruch 11, wobei die Barrierenstruktur (32, 42) zwei Wände umfasst, die jeweils parallel zu einer unterschiedlichen Seitenfläche des ersten (18) und des zweiten (18') Komponenten-Chips angeordnet sind; oder
wobei die Barrierenstruktur (42) entweder den ersten (18) oder den zweiten (18') Chip umgibt.

## Revendications

1. Ensemble électronique (30), présentant :
une plaquette support (12) dotée d'une surface de plaquette supérieure (12') et d'une surface de plaquette inférieure (12") ;
un circuit intégré électronique (14, 14') étant formé dans la plaquette support (12) et comprenant des premier (15) et second (15') plots de contact de circuit intégré sur au moins une surface parmi la surface de plaquette supérieure (12') et la surface de plaquette inférieure (12") ; ladite plaquette support (12) comprenant une cavité traversante de la plaquette (16) présentant des parois (16') qui relient ladite surface de plaquette supérieure (12') à ladite surface de plaquette inférieure (12") ;
une première puce de composant (18) dotée d'une première surface supérieure de la puce de composant, une première surface inférieure de la puce de composant et des premières surfaces latérales de la puce de composant, la première puce de composant (18) étant maintenue dans ladite cavité traversante de la plaquette (16) par contact direct d'au moins une surface latérale de ladite première puce de composant (18) dotée d'un matériau de fixation thermoconducteur (20) qui remplit au moins une partie de ladite cavité traversante de la plaquette (16) ; ladite première puce de composant (18) comprenant au moins un premier plot de contact de composant (19) sur au moins une surface parmi ladite première surface supérieure de la puce de composant et ladite première surface inférieure de la puce de composant ;
une seconde puce de composant (18') dotée d'une seconde surface supérieure de la puce de composant, une seconde surface inférieure de la puce de composant et des secondes surfaces latérales de la puce de composant, la seconde puce de composant (18') étant maintenue dans ladite cavité traversante de la plaquette (16) par contact direct d'au moins une surface latérale de ladite seconde puce de composant (18') avec ledit matériau de fixation thermoconducteur (20) ; ladite seconde puce de composant (18') comprenant au moins une second plot de contact de composant (19') sur au moins une surface parmi ladite seconde surface supérieure de la puce de composant et ladite seconde surface inférieure de la puce de composant ;
dans lequel une barrière (32 ; 42) présentant une conductivité thermique inférieure à une conductivité thermique de ladite plaquette support (12) est maintenue par ledit matériau de fixation thermoconducteur (20) dans ladite cavité traversante de la plaquette (16) entre ladite première(18) et ladite seconde (18') puces de composant ;
et présentant au moins un élément parmi :
un premier conducteur (22) connectant ledit premier plot de contact de circuit intégré (15) et ledit premier plot de contact de composant (19) ; et
un second conducteur (22') connectant ledit second plot de contact de circuit intégré (15') et ledit second plot de contact de composant (19').

2. Ensemble selon la revendication 1, dans lequel les première (18) et seconde (18') puces de composant présentent des première et seconde hauteurs et la barrière (32, 42) présente une hauteur de barrière au moins aussi grande que la plus petite des première et seconde hauteurs ; ou dans lequel la cavité traversante de la plaquette (16) présente une hauteur de cavité et la hauteur de barrière est égale à la hauteur de cavité.

3. Ensemble selon la revendication 1, dans lequel les première (18) et seconde (18') puces de composant présentent chacune un côté le plus proche de la barrière (32, 42) qui présente des première et seconde longueurs, et dans lequel la barrière (32, 42) présente une longueur de barrière au moins aussi grande que la plus petite desdites première et seconde longueurs ; ou dans lequel la cavité traversante de la plaquette (16) présente une longueur de cavité et la longueur de barrière est égale à la longueur de cavité.

4. Ensemble selon la revendication 1, dans lequel le matériau de barrière comprend l'un parmi l'air, la céramique et le verre.

5. Ensemble selon la revendication 1, dans lequel la barrière (32, 42) présente une épaisseur égale à un cinquième ou plus d'une distance entre les première (18) et seconde (18') puces de composant.

6. Ensemble selon la revendication 1, dans lequel le matériau de fixation thermoconducteur (20) maintient les première (18) et seconde (18') puces de composant de sorte que les surfaces supérieures des première (18) et seconde (18') puces de composant sont au même niveau que la surface de plaquette supérieure (12').

7. Ensemble selon la revendication 1, dans lequel une couche métallique (44) recouvre au moins une partie de la surface de plaquette inférieure (12") ainsi que le matériau de fixation thermoconducteur (20) dans la cavité traversante de la plaquette (16).

8. Ensemble selon la revendication 1, dans lequel les parois (16') de la cavité traversante de la plaquette (16) sont recouvertes d'une couche diélectrique (17).

9. Ensemble selon la revendication 1, dans lequel au moins une puce parmi les première (18) et seconde (18') puces de composant est une puce de circuit intégré comprenant un ou plusieurs transistors.

10. Ensemble selon la revendication 1, dans lequel la plaquette support (12) et au moins une puce parmi les première (18) et seconde (18') puces de composant présentent une hauteur différente.

11. Procédé de fabrication d'un ensemble électronique, le procédé comprenant : la fourniture d'une première puce de composant (18) présentant une première surface supérieure de la puce de composant, une première surface inférieure de la puce de composant et des premières surfaces latérales de la puce de composant ; ladite première puce de composant (18) comprenant au moins un premier plot de contact de composant (19) sur ladite première surface supérieure de la puce de composant ;
la fourniture d'une seconde puce de composant (18') présentant une seconde surface supérieure de la puce de composant, une seconde surface inférieure de la puce de composant et des secondes surfaces latérales de la puce de composant ; ladite seconde puce de composant comprenant au moins un second plot de contact de composant (19') sur ladite seconde surface supérieure de la puce de composant ;
la fourniture d'un substrat support présentant une première surface, et la fixation desdites première (18) et seconde (18') surfaces supérieures des puces de composant à ladite première surface dudit substrat support ;
la fourniture d'une plaquette support (12) présentant une surface de plaquette supérieure (12') et une surface de plaquette inférieure (12") ; la formation dans la plaquette support (12) d'un circuit intégré électronique (14, 14') présentant des premiers (15) et seconds (15') plots de contact de circuit intégré sur la surface de plaquette supérieure (12') ;
formant dans la plaquette support (12) une cavité traversante de la plaquette (16) présentant des parois (16') reliant ladite surface de plaquette supérieure (12') à ladite surface de plaquette inférieure (12') ;
la fixation de ladite surface de plaquette supérieure (12') à ladite première surface dudit substrat support de sorte que lesdites première (18) et seconde (18') puces de composant soient disposées à l'intérieur de ladite cavité traversante de la plaquette (16) ;
le positionnement d'une structure de barrière (32, 42) présentant une conductivité thermique inférieure à une conductivité thermique de ladite plaquette support (12) dans ladite cavité traversante de la plaquette (16) entre les première (18) et seconde (18') puces de composant ; le remplissage d'au moins une partie de ladite cavité traversante de la plaquette (16) avec un matériau de fixation thermoconducteur (20) de manière à maintenir les première (18) et seconde (18') puces de composant dans ladite cavité traversante de la plaquette (16) par contact direct d'au moins une surface latérale desdites première (18) et seconde (18') puces de composant avec ledit matériau de fixation thermoconducteur (20) et de manière à maintenir ladite structure de barrière (32, 42) entre les première (18) et seconde (18') puces de composant par contact direct avec ledit matériau de fixation thermoconducteur (20) ;
le détachement du substrat support de la surface supérieure des première (18) et seconde (18') puces de composant et de la surface de plaquette supérieure (12') ; et
au moins un élément parmi :
la formation d'un premier conducteur (22) entre le premier plot de contact de circuit intégré (15) et ledit premier plot de contact de composant (19) ; et
la formation d'un second conducteur (22') entre le second plot de contact de circuit intégré (15') et ledit second plot de contact de composant (19').

12. Ensemble selon la revendication 1 ou procédé selon la revendication 11, dans lesquels ledit matériau de fixation thermoconducteur (20) est un métal.

13. Procédé selon la revendication 11, dans lequel ledit positionnement d'une structure de barrière (32, 42) présentant une conductivité thermique inférieure à une conductivité thermique de ladite plaquette support (12) dans ladite cavité traversante de la plaquette (16) entre les première (18) et seconde (18') puces de composant comprend la fixation de la structure de barrière (32, 42) à ladite première surface dudit substrat support et/ou à au moins une paroi (16') de ladite cavité traversante de la plaquette (16) ; ou
dans lequel ledit positionnement d'une structure de barrière (32) entre les première (18) et seconde (18') puces de composant comprend le positionnement d'une structure sacrificielle entre les première (18) et seconde (18') puces de composant qui peut être enlevée, après ledit remplissage d'au moins une partie de ladite cavité traversante de la plaquette (16) avec un matériau de fixation thermoconducteur (20), pour fournir une structure de barrière (32) faite d'air.

14. Procédé selon la revendication 12, dans lequel ledit remplissage d'au moins une partie de ladite cavité traversante de la plaquette (16) avec ledit métal (20) comprend le dépôt dudit métal par électrodéposition.

15. Appareil selon la revendication 1 ou procédé selon la revendication 11, dans lesquels la structure de barrière (32, 42) comprend deux parois disposées chacune parallèles à une surface latérale différente de l'une des première (18) et seconde (18') puces de composant ; ou
dans lesquels la structure de barrière (42) entoure l'une des première (18) et seconde (18') puces.
